# FASCICULE DE BREVET EUROPEEN

(11) **EP 2 194 544 B1**
(45) Date de publication et mention de la délivrance du brevet: **23.05.2012**
(21) Numéro de dépôt: 09306116.6
(22) Date de dépôt: 20.11.2009
(51) Int. Cl.: H01F 10/32

(54) **Oscillateur radiofréquence à vanne de spin ou à jonction tunnel**
Hochfrequenzoszillator basierend auf Drehventilen oder Tunnelübergängen
Spin-valve or tunnel junction radiofrequency oscillator

(30) Priorité: 01.12.2008 FR 0858161
(43) Date de publication de la demande: 09.06.2010
(73) Titulaire: Commissariat à l'Énergie Atomique et aux Énergies Alternatives, 75015 Paris (FR)
(72) Inventeur: Cyrille, Marie-Claire, 38650, SINARD (FR); Delaet, Bertrand, 38190, BERNIN (FR); Nodin, Jean-Francois, 38120, SAINT EGREVE (FR); Sousa, Véronique, 38000, GRENOBLE (FR)
(74) Mandataire: Vuillermoz, Bruno

(56) Documents cités:
- EP-A1- 2 107 623
- US-A1- 2005 002 126
- KOZICKI M N ET AL: "Mass transport in chalcogenide electrolyte films - materials and applications" JOURNAL OF NON-CRYSTALLINE SOLIDS, NORTH-HOLLAND PHYSICS PUBLISHING. AMSTERDAM, NL, vol. 352, no. 6-7, 15 mai 2006 (2006-05-15), pages 567-577, XP025187128 ISSN: 0022-3093 [extrait le 2006-05-15]

## Description

### DOMAINE DE L'INVENTION

La présente invention appartient au domaine des oscillateurs radiofréquences mettant en oeuvre la technologie des systèmes magnétiques en couches minces.

Elle vise plus particulièrement de tels oscillateurs radiofréquences mettant en oeuvre des vannes de spin ou des jonctions tunnel magnétiques comportant un empilement magnétique d'au moins une couche magnétique libre, une couche magnétique piégée, lesdites couches étant interfacées par une couche intermédiaire.

### ETAT ANTERIEUR DE LA TECHNIQUE

Les oscillateurs radiofréquences sont destinés à fonctionner dans des gammes de fréquences élevées typiquement comprises entre quelques dizaines de mégahertz et quelques dizaines de gigahertz.

Afin de satisfaire les exigences nées du développement, notamment de la téléphonie mobile (cellulaires, portables), outre de la saturation des bandes de fréquences attribuées à la télécommunication, on a proposé de remplacer l'allocation statique desdites bandes de fréquence par une allocation dynamique. Ce principe repose sur la capacité d'analyser le spectre de fréquences, et d'identifier les bandes de fréquences libres afin de pouvoir les utiliser. On parle alors de « radio opportuniste ».

Cependant, afin de mettre en oeuvre ce principe d'allocation dynamique de fréquences, les dispositifs le mettant en oeuvre doivent disposer d'oscillateurs à très larges bandes, et par ailleurs être très performants en bruit de phase, et donc à fort coefficient de qualité Q = f/Δf.

Une solution technique propre à satisfaire ces exigences consiste en la mise en oeuvre d'oscillateurs radiofréquences à électronique de spin. Avec de tels oscillateurs, on dispose d'une large bande de fréquences avec un facteur de qualité Q élevé, outre une accordabilité en fréquence aisée et mettant en oeuvre une architecture relativement simple.

L'électronique de spin utilise le spin des électrons comme degré de liberté supplémentaire, afin de générer des effets nouveaux.

On a montré qu'en faisant passer un courant polarisé en spin à travers une couche mince magnétique, on produit un renversement de son aimantation en l'absence de tout champ magnétique externe. Le courant polarisé en spin peut également générer des excitations magnétiques entretenues, également dénommées oscillations. L'utilisation de l'effet de génération d'excitations magnétiques entretenues dans un dispositif magnétorésistif permet de convertir cet effet en une modulation de résistance électrique directement utilisable dans les circuits électroniques et donc, corolairement, susceptible d'intervenir directement au niveau de la fréquence.

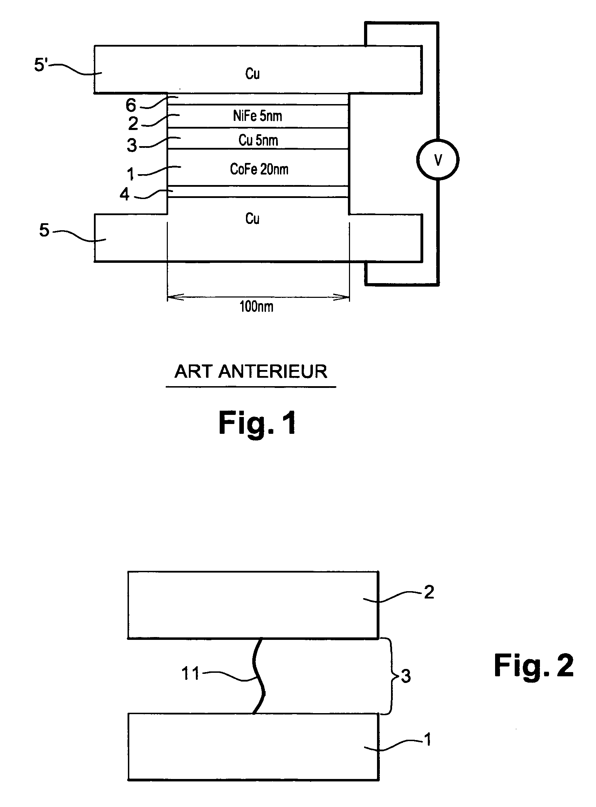

Le document US-5 695 864 décrit divers développements mettant en oeuvre le principe mentionné ci-dessus, et décrit notamment la précession de l'aimantation d'une couche magnétique traversée par un courant électrique polarisé en spin. On a représenté en relation avec la figure 1 un empilement des couches magnétiques susceptibles de constituer un tel oscillateur radiofréquence. Cet empilement est inséré entre deux zones de contact électriques 5', 5, par exemple réalisé en cuivre ou en or.

La couche 2 de cet empilement, dite « couche piégée », présente une aimantation à orientation fixe. Elle peut être constituée d'une couche simple, d'épaisseur typique comprise entre 5 et 100 nanomètres, et par exemple réalisée en cobalt, ou plus généralement en un alliage à base de cobalt et/ou de fer et/ou de nickel (par exemple CoFe ou NiFe). Cette couche piégée 2 peut être simple ou synthétique. Elle remplit la fonction de polariseur. Ainsi, des électrons du courant électrique traversant les couches constitutives du dispositif magnétorésistif perpendiculairement à leur plan, réfléchis ou transmis par le polariseur, sont polarisés avec une direction de spin parallèle à l'aimantation qu'a la couche 2 à l'interface opposé à celle en contact avec une couche antiferromagnétique 6, à laquelle elle est associée et destinée à figer l'orientation de son aimantation.

Cette couche 2 reçoit sur sa face opposée à la face recevant la couche antiferromagnétique 6 une autre couche 3 faisant fonction d'espaceur. Cette couche 3 est de nature métallique, typiquement une couche de cuivre de 3 à 10 nanomètres d'épaisseur, ou est constituée d'une fine couche isolante de type oxyde d'aluminium, d'une épaisseur typique comprise entre 0,5 à 1,5 nanomètre, ou d'oxyde de magnésium, d'une épaisseur typique comprise entre 0,5 à 3 nanomètres. De l'autre côté de l'espaceur 3, est mise en place une couche 1, dite « couche libre », généralement d'épaisseur plus faible que celle de la couche 2. Cette couche peut être simple ou composite. Elle peut également être couplée à une couche antiferromagnétique 4 rapportée sur celle-ci au niveau de sa face opposée à l'interface de la couche 1 avec l'espaceur 3, elle doit simplement rester plus « libre » que la couche piégée. Cette couche 4 est par exemple constituée d'alliage de type Ir₈₀Mn₂₀, de FeMn ou de PtMn.

Le matériau de la couche 1 est en général un alliage à base de cobalt et/ou de fer et/ou de nickel.

Avec les dispositifs de l'art antérieur, on peut ainsi obtenir des émissions radiofréquences très fines sous champ magnétique fort et hors du plan. Cependant, l'amplitude du signal utile reste faible, ce qui peut s'avérer rédhibitoire pour certaines applications. On a ainsi pu mesurer à l'analyseur de spectre sur des vannes de spin des puissances (intégrées sur la bande RF) de l'ordre de -100dBm et sur des jonctions tunnel de l'ordre de -40dBm. Cette puissance rend compte de la variation de la résistance dynamique générée du fait de l'oscillation d'aimantation de la magnétorésistance.

On a décrit, par exemple dans le document US 2007/109147 un oscillateur radiofréquence constitué d'un empilement de couches magnétiques intercalées par une couche intermédiaire réalisée en un matériau isolant et pourvue de chemins de passage du courant électrique traversant ledit empilement, dénommés chemins de passage confiné du courant.

Cependant, le nombre de ces chemins n'est pas ajustable, et en outre, leur diamètre est aléatoire. Ce faisant, on génère des oscillateurs qui ne sont pas accordés, ce qui dégrade la largeur de raie.

Ainsi, l'objectif premier recherché par la présente invention est de conserver voire d'améliorer la qualité des émissions radiofréquences obtenues en termes de finesse, tout en augmentant significativement la puissance afin de se rapprocher autant que faire ce peut des puissances nécessaires pour l'utilisation de tels oscillateurs dans les chaînes de réception radiofréquences.

### EXPOSE DE L'INVENTION

L'invention propose donc un oscillateur radiofréquence intégrant un dispositif magnétorésistif au sein duquel est susceptible de circuler un courant électrique. Ce dispositif ou empilement magnétorésistif comprend :
- une première couche magnétique, dite « couche piégée », dont l'aimantation est de direction fixe ;
- une seconde couche magnétique dite « couche libre » ;
- une couche amagnétique, dite « couche intermédiaire », interposée entre la première et la seconde couche, et réalisée en un matériau isolant.

Il comprend également des moyens aptes à faire circuler un courant d'électrons dans lesdites couches constitutives de l'empilement précité et selon une direction perpendiculaire au plan qui contient lesdites couches.

Selon l'invention, le dispositif magnétorésistif comporte au moins une zone de constriction du courant électrique le traversant, ladite au moins une zone de constriction étant constituée d'un nano-chemin ou nano-fil s'étendant entre la couche piégée et la couche libre, et résultant de la soumission d'un empilement spécifique réalisé entre lesdites couches libre et piégée à une tension propre à le générer, ledit empilement étant constitué d'une bicouche composée d'un électrolyte solide sur lequel a été déposée une électrode soluble métallique, dissoute partiellement dans ledit électrolyte soit par photodissolution (UV), soit par traitement thermique.

On observe en effet que de par la présence d'une ou de plusieurs de telles constrictions dans l'empilement magnétorésistif, de fortes densités de courant sont créées localement et peuvent induire une précession locale de l'aimantation de la couche libre, même si celle-ci est d'une taille (c'est-à-dire de diamètre) micrométrique. En raison de cette possibilité de disposer de plus fortes densités de courant locales, la variation de la résistance dynamique est plus importante et donc le signal utile plus élevé. Il est possible même, pour de très fortes densités de courant, d'atteindre des régimes où la précession de l'aimantation de ladite couche libre se fait suivant de grands angles et hors du plan de ladite couche (et non plus dans le plan comme pour les plus faibles densités de courant). Dans ce cas, on obtient des excitations radiofréquences de plus grande amplitude encore, car les trajectoires de l'aimantation induisent une oscillation de l'aimantation de 360° dans le plan, permettant ainsi de profiter de la totalité de l'amplitude de la magnétorésistance.

Avantageusement, on réalise plusieurs de ces constrictions dans la couche considérée, permettant alors d'obtenir non plus un mais N oscillateurs (dans un plan perpendiculaire à la direction du courant), alors en parallèle. Il a été montré (voir "Mutual Phase-locking of Microwave Spin Torque Nano-Oscillator" - S. Kaka, MR. Pufall, WH. Rippard et al ; NATURE Vol. 437, issue : 7057, pages 389-392, 2005) que dans ce cas, les oscillateurs en parallèle peuvent se coupler par onde de spin et émettre de manière cohérente. La puissance totale émise est alors proportionnelle à N².

Les zones de constriction ainsi obtenues présentent des diamètres typiques s'étendant entre 1 et quelques dizaines de nanomètres.

Selon une variante avantageuse, il est possible d'adjoindre à l'empilement magnétorésistif un polariseur à aimantation perpendiculaire par rapport au plan des couches constitutives de l'empilement, ledit polariseur étant positionné de manière adjacente à la couche libre.

Ce polariseur peut typiquement être réalisé à base d'alliage de cobalt et de platine ou de cobalt et de gadolinium ou une multicouche cobalt/platine ou encore une multicouche cobalt/nickel sur une couche de platine.

La mise en oeuvre d'un tel polariseur permet d'induire la formation d'oscillations radiofréquences en champ magnétique appliqué nul et de plus grande amplitude tout en appliquant des densités de courant plus faibles. Le polariseur est séparé de ladite couche libre par un espaceur métallique, par exemple également réalisé en cuivre.

Selon un premier mode de réalisation de l'invention, la bicouche est constitutive de la couche intermédiaire.

L'électrolyte solide peut être composée d'une matrice isolante à base de chalcogenures, tels que par exemple GeSe, GeS, CuS, Ag₂S, et l'électrode soluble est par exemple constituée de cuivre ou d'argent.

Il est connu qu'en jouant sur la tension appliquée sur ladite bicouche, il est possible de faire varier le diamètre et donc la résistance des nano-fils.

Selon une variante du mode de réalisation précédent, il est également possible de remplacer le chacogcnure par un oxyde tunnel de type SiO₂, TiO₂, NiO₂, SrTiO₃, MgO, Al₂O₃.

Selon un second mode de réalisation de l'invention, la ou les constrictions sont ménagées au dessus de la couche intermédiaire, constituée alors d'un espaceur (mieux connu dans le domaine par l'expression anglo-saxonne « *spacer* »). Le spacer est soit un isolant (une barrière tunnel), soit de nature métallique (une jonction tunnel). Cette ou ces constrictions résultent de la mise en oeuvre d'un électrolyte solide associé à une électrode soluble, en l'espèce constituée par la couche magnétique de ladite couche piégée qui vient se dissoudre dans l'électrolyte solide par photodissolution ou traitement thermique. En appliquant une tension supérieure à une tension seuil (cf. ci-dessus), on forme ainsi de manière irréversible un filament conducteur ferromagnétique au-dessus la barrière tunnel dont le diamètre dépend de la tension appliquée, et plus précisément au sein de la matrice résultant de la dissolution partielle de la couche magnétique de la couche piégée au sein de l'électrolyte solide.

L'invention vise également un procédé de réalisation d'un oscillateur radiofréquence conforme à ceux précédemment décrits.

Ce procédé consiste à intégrer dans un substrat, typiquement réalisé en silicium, l'électrode inférieure conductrice électrique, destinée à réaliser la précession de l'aimantation de l'une des couches d'un empilement magnétique, déposé sur ledit substrat, ledit empilement étant constitué de deux couches de matériaux ferromagnétiques tels que notamment en alliage CoFe ou NiFe, séparées l'une de l'autre par un matériau isolant et notamment un oxyde tel que par exemple de l'alumine, pour constituer une jonction tunnel magnétique, ou par un matériau métallique (vanne de spin).

Selon une première variante de l'invention, on dépose sur la couche inférieure de matériau ferromagnétique de l'empilement, par PVD (« *Physical Vapour Deposition* »), CVD (« *Chemical Vapour Deposition* »), ou par évaporation, une couche constitutive d'un électrolyte solide, tel qu'un chalcogenure GeSe ou GeS ou GeTe ou As₂Se d'une épaisseur variant de 1 à 5 nanomètres. On dépose ensuite par la même technologie une électrode soluble, constituée d'argent ou de cuivre ou de zinc ou d'indium et de platine, et selon également une épaisseur de 1 à 5 nanomètres avant traitement de dissolution.

On soumet alors la bicouche ainsi réalisée à un traitement ultraviolet ou à un traitement thermique, aboutissant à la dissolution, à tout le moins partielle de l'électrode soluble au sein de l'électrolyte solide. Ce faisant, on aboutit par exemple à la constitution d'une matrice CuGeSe ou CuGeS ou AgGeSe ou AgGeS.

On soumet alors l'empilement ainsi traité à une tension V> Vₜₕ ; Vₜₕ étant une tension seuil typiquement comprise entre 0,2 V et 1 V, et corollairement on fait circuler un courant électrique I > Iₛₐₜ au travers de la bicouche. On réalise ainsi un ou plusieurs nano - chemins conducteurs permanents ou irréversibles, dont la taille et la résistance électrique sont fixées par le courant de saturation.

On dépose alors une électrode supérieure conductrice électrique.

On dispose alors d'une zone de constriction tout particulièrement localisée, et notamment limitée à quelques atomes ou à quelques nanomètres en fonction du courant de compliance injecté (Iₛₐₜ) sans pour autant perdre en conductivité électrique.

Au surplus, ce mode de réalisation permet d'aboutir à une très bonne intégration, et donc à un confinement. Cette technologie s'avère par ailleurs relativement facilement industrialisable en raison de la simplicité de fabrication : simples techniques de dépôt, et étape de dissolution. En outre, elle permet d'aboutir à une densité d'intégration élevée. Enfin, elle permet une optimisation de la performance des oscillateurs, en raison de l'injection extrêmement localisée du courant.

L'électrode supérieure est en général déposée après dissolution partielle de l'électrode soluble au sein de l'électrolyte solide. Cependant, les techniques actuelles permettent d'envisager le dépôt de cette électrode avant dissolution de l'électrode soluble.

Selon un autre procédé de réalisation de l'invention, on dépose sur la couche intermédiaire réalisée en oxyde tunnel ou en un matériau métallique, par PVD, CVD, ou par évaporation, une couche constitutive d'un électrolyte solide, tel qu'un chalcogenure GeSe ou GeS ou GeTe ou As₂Se d'une épaisseur variant de 5 à 50 nanomètres.

On dépose sur cette couche la couche constitutive de l'autre couche ferromagnétique, en l'espèce du cobalt, et destinée à jouer partiellement le rôle d'électrode soluble.

On soumet alors la bicouche ainsi réalisée à un traitement ultraviolet ou à un traitement thermique, aboutissant à la dissolution, à tout le moins partielle de l'électrode soluble au sein de l'électrolyte solide.

On soumet alors l'empilement ainsi obtenu au même traitement qu'à celui précédemment décrit, aux fins d'aboutir à la réalisation d'un ou de plusieurs nano-fils ou nano-chemins. Cette fois ci, ceux-ci ne sont pas réalisés au sein de la couche intermédiaire, mais au dessus de celle-ci.

### BREVE DESCRIPTION DES FIGURES

La manière dont l'invention peut être réalisée et les avantages qui en découlent ressortiront mieux des exemples de réalisation qui suivent, donnés à titre indicatif et non limitatif, à l'appui des figures annexées et dans lesquelles les mêmes références correspondent aux mêmes éléments.

Comme déjà dit, la figure 1 est une représentation schématique d'un oscillateur radiofréquence conforme à l'état antérieur de la technique.

La figure 2 est une illustration d'un premier mode de réalisation de l'invention mettant en oeuvre un nano-chemin conducteur entre la couche libre et la couche piégée.

Les figures 3a et 3b illustrent schématiquement la mise en oeuvre d'une bicouche électrolyte solide/électrode soluble pour la réalisation de la structure décrite en figure 2.

Les figures 4a et 4b illustrent une variante des figures 3a et 3b.

Les figures 5a et 5b illustrent une autre forme de réalisation de l'invention, mettant en oeuvre également une bicouche électrolyte solide/électrode soluble, cette dernière étant constituée par la couche ferromagnétique de la couche piégée.

### MODES DE REALISATION DE L'INVENTION

Au sein de ces figures, on a plus particulièrement représenté les seuls empilements des couches magnétiques.

Dans celles-ci, la couche libre oscillante **1** présente une épaisseur typique comprise entre 2 et 50 nanomètres. Elle est réalisée à base d'alliages de fer, cobalt et nickel tel que par exemple CoFe, CoFeB, NiFe, etc.. .

La couche piégée **2** est d'épaisseur équivalente et est réalisée en même matériau. Le piégeage de son aimantation dans le plan de ladite couche est assuré par interaction d'échange avec une couche antiferromagnétique telle que réalisée par exemple à base d'alliages PtMn, IrMn, NiMn, non représentée sur lesdites figures par souci de clarté.

Ces deux couches ferromagnétiques, respectivement couche libre **1** et couche piégée **2** sont séparées l'une de l'autre par une couche intermédiaire **3**, réalisée en un matériau isolant.

Selon l'invention, on réalise au sein de l'empilement ainsi décrit des constrictions en termes de conduction électrique, orientées perpendiculairement au plan des couches, ou parallèlement au sens du courant électrique traversant ledit empilement. Ces constrictions présentent un diamètre variant typiquement entre 1 et quelques dizaines de nanomètres. Après réalisation de l'empilement, celui-ci peut être structuré (ou patterné) afin de lui conférer une section transversale circulaire : on parle alors d'empilements dits en « piliers ». Le diamètre de ces piliers est susceptible de varier entre 50 et quelques centaines de nanomètres.

Selon un premier mode de réalisation de l'invention, représenté au sein de la figure 2, les nano-constrictions sont constituées d'un ou plusieurs chemins ou fils conducteurs **11** s'étendant entre la couche libre **1** et la couche piégée **2**. Dans cette réalisation, la couche intermédiaire faisant fonction d'espaceur **3** est constituée d'une bicouche, respectivement constituée avant tout traitement d'un électrolyte solide **12** et d'une électrode soluble **13**.

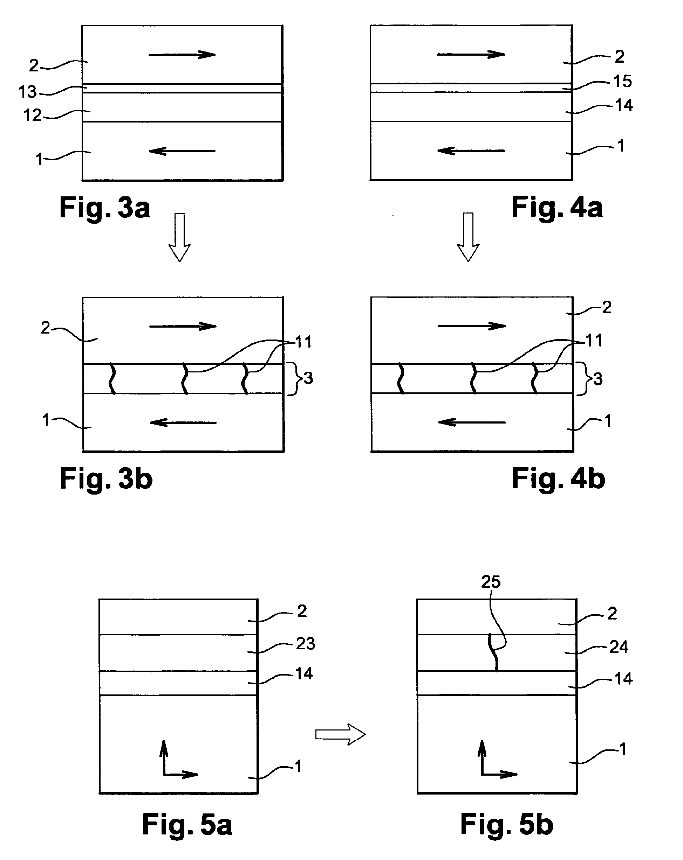

L'électrolyte solide **12** est par exemple constitué d'un chalcogenure de type GeSe, GeS, GeTe, Ag₂S, CuS d'épaisseur typique comprise entre 1 et 5 nanomètres, et l'électrode soluble 13 est par exemple constituée d'une couche de cuivre ou d'argent d'épaisseur comprise entre 1 et 10 nanomètres (voir figures 3a et 3b).

L'électrolyte solide est déposé sur la couche libre **1** par les techniques classiques, telles que PVD (« *Physical Vapor Deposition* »), CVD (« *Chemical Vapor Deposition* ») ou par évaporation. Ces techniques de dépôt s'appliquent également pour l'électrode soluble.

Afin d'aboutir à la création d'un nano-chemin ou d'un nano-fil conducteur **11**, constitutif de la constriction visée par l'invention, on soumet tout d'abord la bicouche ainsi constituée à un traitement de photodissolution (par exemple par traitement ultraviolet) ou un traitement thermique, aboutissant à la dissolution à tout le moins partielle de la couche **13** constitutive de l'électrode soluble au sein d'un électrolyte solide **12**.

Ce faisant, on aboutit par exemple à la constitution d'une matrice de type CuGeSe ou CuGeS ou encore AgGeS. L'épaisseur de l'électrode n'est pas modifiée de manière notable.

Après traitement de dissolution de l'électrode soluble au sein de l'électrolyte solide, on dépose la couche piégée **2**, puis on soumet l'ensemble de l'empilement décrit, c'est-à-dire couche piégée, bicouche et couche libre à une tension supérieure à la tension seuil Vₜₕ, typiquement comprise entre 0,2 Volt et 1 Volt. Il se crée des nano-chemins ou nano-fils conducteurs de manière irréversible et donc permanents entre la couche piégée et la couche libre. La taille et la résistance électrique de ces nano-chemins sont fixées par le courant de saturation. On dispose ainsi de zones de constriction limitées à quelques atomes ou à quelques nanomètres, permettant d'obtenir à ce niveau des densités de courant élevées, but poursuivi par la présente invention. Cette tension dépend des matériaux en jeu dans la bicouche et de l'épaisseur de cette bicouche.

Cette forme de réalisation particulière permet de contrôler la résistance du dispositif et la largeur du nanochemin en ajustant la tension de polarisation du dispositif Vbias.

De plus, elle permet de fabriquer des dispositifs de grand diamètre, typiquement de plusieurs centaines de nanomètres, puisqu'aussi bien le courant traversant le dispositif est confiné par les nanochemins.

Si nécessaire, l'ensemble obtenu peut-être soumis à un champ magnétique statique de quelques dizaines à quelques centaines d'Oersteds afin d'induire des excitations radiofréquences au sein de la couche libre **1**.

On obtient un nombre N de nano-constrictions **8** en parallèle, dans un même plan parallèle au plan desdites couches, limitant le passage du courant électrique I traversant l'empilement selon une direction perpendiculaire à ce plan. Il en résulte une augmentation locale de la densité de courant au niveau de chacune de ces constrictions, induisant, en présence d'un champ magnétique extérieur, la précession locale de l'aimantation de la couche libre **1**.

En raison de la présence de ces différentes constrictions, on obtient N nano-oscillateurs couplés par ondes de spin au sein d'un même dispositif.

Selon une variante de cette forme de réalisation visée au sein des figures 4a et 4b, la bicouche constitutive de la couche intermédiaire **3** est composé d'un oxyde **14** faisant fonction de barrière tunnel type SiO₂, TiO₂, NiO₂, SrTiO₃, MgO, Al₂O₃, d'épaisseur typique comprise entre 1 et 5 nanomètres, et d'une électrode soluble **15** par exemple réalisée en cuivre ou en argent. L'électrode soluble peut être partiellement dissoute dans l'oxyde tunnel par traitement thermique de type recuit.

Là encore, en appliquant au dispositif une tension supérieure à la tension seuil, on forme un ou plusieurs filaments de cuivre ou d'argent à l'intérieur de l'oxyde tunnel, permettant d'assurer le confinement du courant à l'intérieur du dispositif.

Selon une mode de réalisation de l'invention illustré au sein des figures 5a et 5b, on réalise les constrictions par chemins conducteurs, cette fois non plus réalisés au niveau de la couche intermédiaire **3** faisant fonction de spacer, mais au dessus de cette dernière.

A cet effet, on dépose sur la couche d'oxyde tunnel **14**, elle-même déposée sur la couche libre **1**, et constituée par exemple d'AlOx, MgO, StO d'une épaisseur typique de 1 à 2 nanomètres, une matrice isolante **23** à base de chalcogenure, par exemple de type GeSe, GeS, CuS, Ag₂S, d'épaisseur comprise entre 1 et 5 nanomètres.

On dépose au dessus de l'ensemble ainsi réalisé, une couche ferromagnétique par exemple réalisée en cobalt, constitutive de la couche piégée **2** (couplée par couplage d'échange avec une couche antiferromagnétique non représentée), qui va en outre constituer l'électrode soluble et être dissoute partiellement dans la matrice chalcogenure **23** par photodissolution ou traitement thermique.

En appliquant à l'empilement ainsi réalisé une tension supérieure à une tension seuil, on forme de manière irréversible un filament conducteur ferromagnétique **25** au dessus de la barrière tunnel **14**. Là encore, le diamètre de ce filament conducteur est dépendant de la tension Vbias.

Le filament conducteur **25** devient donc une nanosource d'injection des électrons polarisés en spin, alors même que la couche libre **1** peut rester de taille (diamètre) micrométrique et ce, afin d'obtenir une meilleure cohérence des oscillations et une faible largeur de raie.

Ce mode de réalisation permet de contrôler la résistance du dispositif et la largeur du filament conducteur par action sur la tension Vbias.

Il permet également une meilleure cohérence de rotation de l'aimantation dans la couche libre et une plus grande simplicité de fabrication.

La couche piégée comporte un filament en cobalt par exemple avec contrôle de son anisotropie de forme par action sur la tension Vbias. Ainsi, plus la tension appliquée est faible, plus le filament sera étroit et plus son anisotropie sera grande. Dans ce cas, des oscillations peuvent être obtenues en champ nul.

Si le spacer est isolant, on obtient avec un tel dispositif un grand signal de sortie via la jonction tunnel magnétique ainsi obtenue.

Le spacer peut cependant être métallique, et faire ainsi fonction de vanne de spin.

## Revendications

1. Oscillateur radiofréquence intégrant un dispositif magnétorésistif au sein duquel est susceptible de circuler un courant électrique, ledit dispositif magnétorésistif comprenant :
- une première couche magnétique, dite « couche piégée » (2), dont l'aimantation est de direction fixe ;
- une seconde couche magnétique dite « couche libre » (1) ;
- une couche amagnétique (3), dite « couche intermédiaire », interposée entre la première et la seconde couche, électriquement isolante ;
l'oscillateur comprenant en outre des moyens aptes à faire circuler un courant d'électrons dans lesdites couches constitutives de l'empilement précité et selon une direction perpendiculaire au plan qui contient lesdites couches ;
***caractérisé* en ce que** le dispositif magnétorésistif comporte au moins une zone de constriction (11, 25) du courant électrique le traversant, et **en ce que** la au moins une zone de constriction est constituée d'un nano-chemin ou nano-fil s'étendant entre la couche piégée (2) et la couche libre (1), et résultant de la soumission d'un empilement réalisé entre lesdites couches libre (1) et piégée (2) à une tension propre à le générer, ledit empilement étant constitué d'une bicouche composée d'une matrice isolante sur laquelle a été déposée une électrode soluble métallique, dissoute partiellement dans ladite matrice soit par photodissolution (UV), soit par traitement thermique.

2. Oscillateur radiofréquence selon la revendication 1, ***caractérisé* en ce que** la matrice isolante est à base de chalcogenure choisi dans le groupe comprenant GeSe, GeS, CuS, Ag₂S.

3. Oscillateur radiofréquence selon la revendication 1, ***caractérisé* en ce que** la matrice isolante est composée d'un oxyde tunnel choisi dans le groupe comprenant SiO₂, TiO₂, NiO₂, SrTiO₃, MgO, Al₂O₃.

4. Oscillateur radiofréquence selon l'une des revendications 1 à 3, ***caractérisé* en ce qu'**il est constitué d'un nombre N d'oscillateurs en parallèle, correspondant au nombre de zones de constrictions du courant d'électrons réalisées, lesdits oscillateurs étant couplés entre eux par onde de spin.

5. Oscillateur radiofréquence selon l'une des revendications 1 à 4, ***caractérisé* en ce que** la couche intermédiaire est constituée par l'empilement composé de la bicouche matrice isolante / électrode soluble, et **en ce que** l'électrode soluble est constituée de cuivre ou d'argent.

6. Oscillateur radiofréquence selon l'une des revendications 1 et 2, ***caractérisé* en ce que** la couche intermédiaire (3) est constitué d'un oxyde tunnel ou d'une couche métallique, **en ce que** ladite couche intermédiaire (3) reçoit sur sa face opposée à la face en contact avec la couche libre (1) une couche composée d'une matrice isolante (23), revêtue à son tour de la couche piégée, ladite couche piégée étant partiellement dissoute dans la matrice par photodissolution ou par traitement thermique, l'empilement magnétique en résultant étant est soumis à une tension propre à générer un ou plusieurs nano-chemins ou nano-fils conducteurs (25) au sein de la matrice (24) résultant de la dissolution partielle de la couche piégée au sein de la matrice isolante, s'étendant entre la couche piégée (2) et la couche libre (1), et constitutifs des zones de constrictions.

7. Oscillateur radiofréquence selon la revendication 6, ***caractérisé* en ce que** l'oxyde tunnel constitutif de la couche intermédiaire (3) est réalisé en un oxyde choisi dans le groupe comprenant d'AlOx, MgO, SrTiO₃.

8. Procédé pour la réalisation d'un oscillateur radiofréquence, consistant :
• à intégrer dans un substrat, typiquement réalisé en silicium, une électrode inférieure conductrice électrique, destinée à réaliser la précession de l'aimantation de l'une des couches d'un empilement magnétique, déposé sur ledit substrat,
• à déposer sur ledit substrat une première couche d'un matériau ferromagnétique ;
• à déposer sur cette première couche, par PVD (« *Physical Vapour Deposition* »), CVD (« *Chemical Vapour Deposition* »), ou par évaporation, une couche constitutive d'une matrice isolante ;
• à déposer ensuite sur la matrice isolante par la même technologie une électrode soluble, constituée d'argent ou de cuivre ou de zinc ou d'indium et de platine ;
• à soumettre alors la bicouche ainsi réalisée à un traitement ultraviolet ou à un traitement thermique, aboutissant à la dissolution, à tout le moins partielle de l'électrode soluble au sein de la matrice isolante ;
• à déposer sur la bicouche postérieurement audit traitement une seconde couche en un matériau ferromagnétique, l'empilement résultant de ladite première couche en matériau ferromagnétique, de la bicouche et de ladite seconde couche en matériau ferromagnétique étant apte à faire fonction de barrière tunnel ;
• à soumettre alors l'ensemble de l'empilement ainsi traité à une tension suffisante pour réaliser un ou plusieurs nano-chemins conducteurs permanents ou irréversibles entre la première et la seconde couche en matériau ferromagnétique ,
• à déposer une électrode supérieure conductrice électrique.

9. Procédé pour la réalisation d'un oscillateur radiofréquence selon la revendication 8, ***caractérisé* en ce que** la matrice isolante est un chalcogénure GeSe ou GeS ou GeTe ou As₂Se.

10. Procédé pour la réalisation d'un oscillateur radiofréquence selon la revendication 8, ***caractérisé* en ce que** la matrice isolante est oxyde tunnel de type SiO₂, TiO₂, NiO₂, SrTiO₃, MgO, Al₂O.

11. Procédé pour la réalisation d'un oscillateur radiofréquence, consistant :
• à intégrer dans un substrat, typiquement réalisé en silicium, une électrode inférieure conductrice électrique, destinée à réaliser la précession de l'aimantation de l'une des couches d'un empilement magnétique, déposé sur ledit substrat,
• à déposer sur ledit substrat une première couche d'un matériau ferromagnétique ;
• à déposer sur cette première couche en matériau ferromagnétique une couche intermédiaire, de nature isolante ou métallique ;
• à déposer sur ladite couche intermédiaire par PVD (« *Physical Vapour Deposition* »), CVD (« *Chemical Vapour Deposition* »), ou par évaporation, une couche constitutive d'une matrice isolante, telle qu'un chalcogénure GeSe ou GeS ou GeTe ou As₂Se ;
• à déposer ensuite sur la matrice isolante une seconde couche en matériau ferromagnétique, destinée à jouer partiellement le rôle d'électrode soluble, constituant ainsi avec la couche constitutive de la matrice isolante une bicouche, l'empilement résultant de ladite première couche en matériau ferromagnétique, de la bicouche et de ladite seconde couche en matériau ferromagnétique étant apte à faire fonction de barrière tunnel ou de vanne de spin selon que la couche intermédiaire est isolante ou métallique ;
• à soumettre alors la bicouche ainsi réalisée à un traitement ultraviolet ou à un traitement thermique, aboutissant à la dissolution, à tout le moins partielle de l'électrode soluble au sein de la matrice isolante ;
• à soumettre alors l'ensemble de l'empilement ainsi traité à une tension suffisante pour réaliser un ou plusieurs nano-chemins conducteurs permanents ou irréversibles au sein de la bicouche ainsi réalisée ;
• à déposer une électrode supérieure conductrice électrique.

## Claims

1. Radio-frequency oscillator with built-in magnetoresistive device in which an electric current is able to flow, said magnetoresistive device including:
- a first magnetic layer, known as the "trapped layer" (2), whereof the magnetization is of fixed direction;
- a second magnetic layer known as the "free layer" (1);
- a non-magnetic layer (3), known as the "intermediate layer", interposed between the first and second layer, electrically non-conductive;
the oscillator further including means capable of causing an electron current to flow in said layers constituting the aforementioned stack and in a direction perpendicular to the plane which contains said layers;
***characterized* in that** the magnetoresistive device comprises at least one constriction zone (11, 25) of the electric current passing through it, and **in that** the at least one constriction zone is constituted by a nano-path or nano-wire extending between the trapped layer (2) and the free layer (1), and resulting from the subjection of a stack implemented between said free (1) and trapped (2) layers to a voltage suitable for generating it, said stack being constituted by a bi-layer consisting of an insulating matrix onto which has been deposited a soluble metal electrode, partially dissolved in said matrix either by photodissolution (UV), or by heat treatment.

2. Radio-frequency oscillator as claimed in claim 1, ***characterized* in that** the insulating matrix consists of a chalcogenide-selected from the group that includes GeSe, GeS, CuS, Ag₂S.

3. Radio-frequency oscillator as claimed in claim 1, ***characterized* in that** the matrix consists of a tunnel oxide selected from the group that includes SiO₂, TiO₂, NiO₂, SrTiO₃, MgO, Al₂O₃.

4. Radio-frequency oscillator as claimed in one of claims 1 to 3, ***characterized* in that** it is constituted by a number N of oscillators in parallel, corresponding to the number of electron current constriction zones implemented, said oscillators being coupled to each other by spin wave.

5. Radio-frequency oscillator as claimed in one of claims 1 to 4, ***characterized* in that** the intermediate layer is constituted by the stack consisting of the insulating matrix/soluble electrode bi-layer, and **in that** the soluble electrode is constituted by copper or silver.

6. Radio-frequency oscillator as claimed in one of claims 1 and 2, ***characterized* in that** the intermediate layer (3) is constituted by a tunnel oxide or a metal layer, **in that** said intermediate layer (3) receives on its face opposite the face in contact with the free layer (1) a layer consisting of an insulating matrix (23) covered in its turn with the trapped layer, said trapped layer being partially dissolved in the matrix by photodissolution or by heat treatment, the resulting magnetic stack being subjected to a voltage suitable for generating one or more conductive nano-paths or nano-wires (25) within the matrix (24) resulting from the partial dissolution of the trapped layer in the insulating matrix, extending between the trapped layer (2) and the free layer (1), and constituting constriction zones.

7. Radio-frequency oscillator as claimed in claim 6, ***characterized* in that** the tunnel oxide constituting the intermediate layer (3) is made out of an oxide selected from the group that includes AlOx, MgO, SrTiO₃.

8. Method for implementing a radio-frequency oscillator, comprising:
• building into a substrate, typically made out of silicon, an electrically conductive lower electrode, intended to implement the magnetization precession of one of the layers of a magnetic stack, deposited on said substrate,
• depositing onto said substrate a first layer of a ferromagnetic material ;
• depositing onto this first layer, by Physical Vapour Deposition (PVD), Chemical Vapour Deposition (CVD, or by evaporation, a layer constituting an insulating matrix ;
• then depositing onto the insulating matrix using the same technology a soluble electrode, constituted by silver or copper or zinc or indium and platinum;
• then subjecting the bi-layer so implemented to ultra-violet treatment or heat treatment, leading to the at least partial dissolution of the soluble electrode in the insulating matrix;
• depositing onto the bi-layer subsequent to said treatment a second layer of ferromagnetic material, the stack constituted by the first layer of ferromagnetic material, the bi-layer and of the second layer of ferromagnetic material acting as a tunnel barrier;
• then subjecting the whole of the stack so treated to sufficient voltage to make one or more permanent or irreversible conductive nano-paths between the first and the second layer of ferromagnetic material ;
• depositing an electrically conductive upper electrode.

9. Method for implementing a radio-frequency oscillator according to claim 8;
***characterized* in that** the insulating matrix is a chalcogenide GeSe or GeS or GeTe or As₂Se;

10. Method for implementing a radio-frequency oscillator according to claim 8, ***characterized* in that** the insulating matrix is a tunnel oxide selected from the group that includes SiO₂, TiO₂, NiO₂, SrTiO₃, MgO, Al₂O₃.

11. Method for implementing a radio-frequency oscillator, comprising:
• building into a substrate, typically made out of silicon, an electrically conductive lower electrode, intended to implement the magnetization precession of one of the layers of a magnetic stack, deposited on said substrate,
• depositing onto said substrate a first layer of a ferromagnetic material ;
• a depositing onto this first layer, by Physical Vapour Deposition (PVD), Chemical Vapour Deposition (CVD, or by evaporation, a layer constituting an insulating matrix such as a chalcogenide GeSe or GeS or GeTe or As₂Se;
• then depositing onto the insulating matrix a second layer of ferromagnetic material, intended to partially act as a soluble electrode, thus constituting a bi-layer with the layer forming the insulating matrix, the stack constituted by the first layer of ferromagnetic material, the bi-layer and of the second layer of ferromagnetic material acting as a tunnel barrier or as a spin valve depending as to whether the intermediate layer is insulating or metallic ,
• then subjecting the bi-layer so implemented to ultra-violet treatment or heat treatment, leading to the at least partial dissolution of the soluble electrode in the insulating matrix
• then subjecting the whole of the stack so treated to sufficient voltage to make one or more permanent or irreversible conductive nano-paths within the bi-layer thus realised;
• depositing an electrically conductive upper electrode.

## Patentansprüche

1. Radiofrequenzoszillator, in den eine magnetische Widerstandsvorrichtung integriert ist, in der ein elektrischer Strom fließen kann, wobei die magnetische Widerstandsvorrichtung umfasst:
- eine erste magnetische Schicht, "eingeschlossene Schicht" (2) genannt, deren Magnetisierung von einer feststehenden Richtung ist;
- eine zweite magnetische Schicht, "freie Schicht" (1) genannt;
- eine zwischen die erste und zweite Schicht eingesetzte, elektrisch isolierende, nicht magnetische Schicht (3), "Zwischenschicht" genannt;
wobei der Oszillator darüber hinaus Einrichtungen umfasst, die einen Elektronenstrom in den, die vorgenannte Schichtung bildenden Schichten und in einer Richtung senkrecht zu der die Schichten enthaltenden Ebene fließen lassen können;
**dadurch gekennzeichnet, dass** die magnetische Widerstandsvorrichtung mindestens einen Verengungsbereich (11, 25) für den sie durchfließenden elektrischen Strom umfasst, und dass der mindestens eine Verengungsbereich aus einer Nano-Bahn oder einer Nano-Ader besteht, die/der sich zwischen der eingeschlossenen Schicht (2) und der freien Schicht (1) erstreckt und sich daraus ergibt, dass eine zwischen der freien (1) und eingeschlossenen (2) Schicht hergestellte Schichtung einer diese zu erzeugen geeigneten Spannung ausgesetzt wird, wobei die Schichtung aus einer Doppelschicht besteht, die sich aus einer isolierenden Matrix zusammensetzt, auf der eine lösliche metallische Elektrode abgeschieden wurde, die sich teilweise in der Matrix entweder durch lichtbedingte Auflösung (UV) oder thermische Behandlung aufgelöst hat.

2. Radiofrequenzoszillator nach Anspruch 1, **dadurch gekennzeichnet, dass** die isolierende Matrix auf Basis von Chalkogenid vorliegt, das aus der Gruppe ausgewählt ist, die GeSe, GeS, CuS und Ag₂S umfasst.

3. Radiofrequenzoszillator nach Anspruch 1, **dadurch gekennzeichnet, dass** die isolierende Matrix aus einem Tunneloxid besteht, das aus der Gruppe ausgewählt ist, die SiO₂, TiO₂, NiO₂, SrTiO₃, MgO und Al₂O₃ umfasst.

4. Radiofrequenzoszillator nach einem der Ansprüche 1 bis 3, **dadurch gekennzeichnet, dass** er aus einer Anzahl N von parallel angeordneten Oszillatoren besteht, die der Anzahl von gebildeten Verengungsbereichen für den Elektronenstrom entspricht, wobei die Oszillatoren untereinander mittels einer Spinwelle verbunden sind.

5. Radiofrequenzoszillator nach einem der Ansprüche 1 bis 4, **dadurch gekennzeichnet, dass** die Zwischenschicht aus einer Schichtung besteht, die sich aus einer Doppelschicht aus isolierender Matrix/löslicher Elektrode zusammensetzt, und dass die lösliche Elektrode aus Kupfer oder Silber besteht.

6. Radiofrequenzoszillator nach einem der Ansprüche 1 und 2, **dadurch gekennzeichnet, dass** die Zwischenschicht (3) aus einem Tunneloxid oder einer Metallschicht besteht, dass die Zwischenschicht (3) auf ihrer Seite, die der Seite entgegengesetzt ist, die mit der freien Schicht (1) in Kontakt ist, eine aus einer isolierenden Matrix (23) zusammengesetzte Schicht aufnimmt, die wiederum mit der eingeschlossenen Schicht beschichtet ist, wobei sich die eingeschlossene Schicht durch lichtbedingte Auflösung oder thermische Behandlung teilweise in der Matrix aufgelöst hat, wobei die sich daraus ergebende magnetische Schichtung einer Spannung ausgesetzt wird, die sich dazu eignet, eine Nano-Leiterbahn oder eine Nano-Leiterader oder mehrere Nano-Leiterbahnen oder Nano-Leiteradern (25) in der Matrix (24), die sich aus der teilweisen Auflösung der eingeschlossenen Schicht in der isolierenden Matrix ergibt, zu erzeugen, die sich zwischen der eingeschlossenen Schicht (2) und der freien Schicht (1) erstrecken und Verengungsbereiche bilden.

7. Radiofrequenzoszillator nach Anspruch 6, **dadurch gekennzeichnet, dass** das die Zwischenschicht (3) bildende Tunneloxid aus einem Oxid hergestellt ist, das aus der Gruppe ausgewählt ist, die AlOx, MgO und SrTiO₃ umfasst.

8. Verfahren zur Herstellung eines Radiofrequenzoszillators, das darin besteht:
• in ein typischerweise aus Silicium hergestelltes Substrat eine elektrisch leitfähige untere Elektrode zu integrieren, die dazu bestimmt ist, die Präzession der Magnetisierung einer der Schichten einer magnetischen Schichtung zu bewerkstelligen, die auf dem Substrat abgeschieden ist,
• auf dem Substrat eine erste Schicht aus einem ferromagnetischen Material abzuscheiden;
• auf dieser erster Schicht durch PVD ("*Physical Vapour Deposition*"), CVD ("*Chemical Vapour Deposition*") oder Verdampfung eine Schicht abzuscheiden, die eine isolierende Matrix bildet;
• dann auf der isolierenden Matrix durch die selbe Technologie eine lösliche Elektrode abzuscheiden, die aus Silber oder Kupfer oder Zink oder Indium und Platin besteht;
• nun die so hergestellte Doppelschicht einer Ultraviolettbehandlung oder einer thermischen Behandlung zu unterziehen, die zur zumindest teilweisen Auflösung der löslichen Elektrode in der isolierenden Matrix führt;
• nach der Behandlung auf der Doppelschicht eine zweite Schicht aus ferromagnetischem Material abzuscheiden, wobei die sich ergebende Schichtung aus der ersten Schicht aus ferromagnetischem Material, der Doppelschicht und der zweiten Schicht aus ferromagnetischem Material in der Lage ist, als Tunnelsperrschicht zu dienen;
• dann die Einheit der so behandelten Schichtung einer Spannung auszusetzen, die ausreicht, um eine oder mehrere permanente oder irreversible Nano-Leiterbahn/en zwischen der ersten und zweiten Schicht aus ferromagnetischem Material herzustellen,
• eine elektrisch leitfähige obere Elektrode abzuscheiden.

9. Verfahren nach Anspruch 8 zur Herstellung eines Radiofrequenzoszillators, **dadurch gekennzeichnet, dass** es sich bei der isolierenden Matrix um ein Chalkogenid GeSe oder GeS oder GeTe oder As₂Se handelt.

10. Verfahren nach Anspruch 8 zur Herstellung eines Radiofrequenzoszillators, **dadurch gekennzeichnet, dass** die isolierende Matrix ein Tunneloxid der Art SiO₂, TiO₂, NiO₂, SrTiO₃, MgO, Al₂O₃ ist.

11. Verfahren zur Herstellung eines Radiofrequenzoszillators, das darin besteht:
• in ein typischerweise aus Silicium hergestelltes Substrat eine elektrisch leitfähige untere Elektrode zu integrieren, die dazu bestimmt ist, die Präzession der Magnetisierung einer der Schichten einer magnetischen Schichtung zu bewerkstelligen, die auf dem Substrat abgeschieden ist,
• auf dem Substrat eine erste Schicht aus einem ferromagnetischen Material abzuscheiden;
• auf dieser erster Schicht aus ferromagnetischem Material eine Zwischenschicht von isolierender oder metallischer Beschaffenheit abzuscheiden;
• auf der Zwischenschicht durch PVD ("*Physical Vapour Deposition*"), CVD ("*Chemical Vapour Deposition*") oder Verdampfung eine Schicht abzuscheiden, die eine isolierende Matrix bildet, wie etwa ein Chalkogenid GeSe oder GeS oder GeTe oder As₂Se;
• dann auf der isolierenden Matrix eine zweite Schicht aus ferromagnetischem Material abzuscheiden, die dazu bestimmt ist, teilweise die Rolle der löslichen Elektrode zu spielen, die somit mit der die isolierende Matrix bildenden Schicht eine Doppelschicht bildet, wobei die sich ergebende Schichtung aus der ersten Schicht aus ferromagnetischem Material, der Doppelschicht und der zweiten Schicht aus ferromagnetischem Material dazu in der Lage ist, je nachdem, ob die Zwischenschicht isolierend oder metallisch ist, als Tunnelsperrschicht oder Spin-Ventil zu dienen;
• die so hergestellte Doppelschicht nun einer Ultraviolettbehandlung oder einer thermischen Behandlung zu unterziehen, die zur zumindest teilweisen Auflösung der löslichen Elektrode in der isolierenden Matrix führt,
• dann die Einheit der so behandelten Schichtung einer Spannung auszusetzen, die ausreicht, um eine oder mehrere permanente oder irreversible Nano-Leiterbahn/en in der so hergestellten Doppelschicht herzustellen;
• eine elektrisch leitfähige obere Elektrode abzuscheiden.
